# EUROPEAN PATENT APPLICATION

(11) **EP 1 594 353 A1**
(43) Date of publication of application: **09.11.2005**
(21) Application number: 04707622.9
(22) Date of filing: 03.02.2004
(51) Int. Cl.: H05K 3/46, H05K 1/02

(54) **HIGH FREQUENCY MULTILAYER PRINTED WIRING BOARD**

(30) Priority: 13.02.2003 JP 2003034974
(71) Applicant: MATSUSHITA ELECTRIC INDUSTRIAL CO., LTD., Kadoma-shi, Osaka 571-8501 (JP)
(72) Inventor: KAWAI, Takatoshi, Shizuoka, 432-0852 (JP); SHIBUYA, Hideo, Kanagawa, 226-0015 (JP)
(74) Representative: Balsters, Robert
(86) International application number: PCT/JP2004/001039
(87) International publication number: WO 2004/073368

(57) **Abstract**

A high frequency multilayer printed circuit board including an intermediate portion printed board 3 having holes each having a metal film formed in a side surface thereof, a lower portion printed board 4 in which high frequency circuits 1 each surrounded by an earth pattern are mounted on one surface, while the other surface is formed as an earth pattern, and an upper portion printed board 5 in which other high frequency circuits 2 needing to be shielded from the high frequency circuits 1 are mounted on one surface, while the other surface is formed as an earth pattern. The high frequency circuits 2 mounted on the upper portion printed board 5 and the high frequency circuits 1 mounted on the lower portion printed board 4 are made adjacent to each other alternately above and below so that they can be shielded surely.

## Description

### Technical Field

The present invention relates to a high frequency multilayer printed circuit board for use in communication equipment or electronic equipment, and particularly relates to a high frequency multilayer printed circuit board mounted with a plurality of high frequency circuits needing to be shielded.

### Background Art

The following structure would be generally made when a plurality of high frequency circuits needing to be sluelded are mounted on one printed circuit board. That is, an earth pattern is formed around a board pattern of each high frequency circuit. Through holes are provided around each high frequency circuit so as to form a shield wall in the thickness direction of a dielectric of the printed circuit board. Each high frequency circuit is covered with a shielding case electrically connected to the earth pattern.

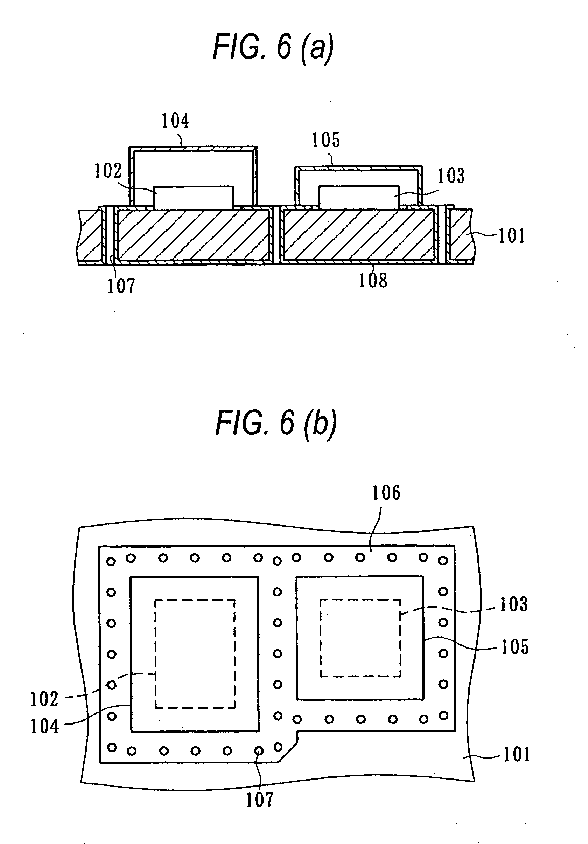

A structure as shown in Fig. 6(a) can be cited as such a typical shield structure. A printed circuit board 101 having such a shield structure is mounted with a high frequency circuit 102 and a high frequency circuit 103. The upper portions of the high frequency circuits 102 and 103 are covered with a shielding case 104 and a shielding case 105 individually not to have a damaging effect on each other.

Further, the high frequency circuit 102 and the high frequency circuit 103 are surrounded by a component side earth pattern 106, while the shielding case 104 and the shielding case 105 are connected to the component side earth pattern 106 by brazing, soldering or the like. This component side earth pattern 106 is connected to a back side earth pattern 108 through a plurality of through holes 107 provided around the high frequency circuit 102 and the high frequency circuit 103. At the same time, the through holes 107 form a shield wall in the thickness direction of a dielectric of the printed circuit board 101.

In addition, as shown in Fig. 6(b), the through holes 107 are provided to surround the high frequency circuit 102 mounted inside the shielding case 104 and the high frequency circuit 103 mounted inside the shielding case 105. Accordingly, when the intervals of the through holes 107 are narrowed, a shielding effect over a high frequency range can be expected between the high frequency circuit 102 and the high frequency circuit 103.

On the other hand, a technique for supporting higher-speed or higher-frequency equipment has been proposed (for example, as disclosed in Japanese Patent Publication No. 10-335882). That is, each high frequency circuit is surrounded by a long groove penetrating a printed circuit board, with the exception of at least a part of the circumference thereof. A metal film is formed on the wall surface of this long groove by plating or the like. This metal film is connected to an earth pattern so as to form an effective shield.

In addition, in order to attain reduction in size and weight of equipment or reduction in cost, there has been proposed a technique in which a high frequency shield structure is formed using a multilayer printed circuit board (for example, as disclosed in Japanese Patent Publication No. 5-79995).

However, in the aforementioned background-art shield structures, the frequency in each circuit increases when a plurality of high frequency circuits needing an shielding effect from one another are disposed closely to one another in order to miniaturize the equipment. As the operation speed of each circuit increases, the wavelength of signals having influence on each other becomes shorter. Thus, there has been a problem that the signals can pass even an extremely slight gap.

To solve this problem, the intervals of the through holes disposed among the high frequency circuits disposed closely to one another and needing to be shielded from one another are narrowed as described previously. Further, long grooves are made among the high frequency circuits, and a metal film is formed on the wall surface of each long groove. This metal film is formed as an earth pattern. However, in consideration of miniaturization of equipment, circuit components or circuit patterns cannot be disposed in the portions where the through holes or the long grooves are provided. Thus, there has been a problem that the degree of freedom to wire circuit patterns is impaired.

### Disclosure of the Invention

The present invention was developed in consideration of such circumstances. An object of the present invention is to provide a high frequency multilayer printed circuit board which can provide shielding at a low price and surely for equipment having a plurality of high frequency circuits needing a shield effect from one another.

According to the present invention, a printed circuit board mounted with a plurality of high frequency circuits needing to be shielded, includes: an intermediate portion printed board in which holes are made in positions where high frequency circuits will be disposed respectively, and a metal film is formed in a side surface of each of the holes; a lower portion printed board in which high frequency circuits each surrounded by an earth pattern are mounted on one surface, while the other surface is formed as an earth pattern; and an upper portion printed board in which other high frequency circuits needing to be shielded from the high frequency circuits are mounted on one surface, and an earth pattern is formed around each of the other high frequency circuits, while the other surface is formed as an earth pattern. The printed circuit board is characterized in that: the high frequency circuits mounted on the lower portion printed board are made adjacent to the high frequency circuits mounted on the upper portion printed board, while these lower portion printed board and upper portion printed board are put on each other through the intermediate portion printed board; a surface of the upper printed board facing the high frequency circuits mounted on the lower portion printed board serves as an earth pattern of the upper printed board; a surface of the lower printed board facing the high frequency circuits mounted on the upper portion printed board serves as an earth pattern of the lower printed board; and the earth pattern of the lower pattern printed board, the metal film of the side surface of each of the holes of the intermediate portion printed board, and the earth pattern of the upper portion printed board are connected electrically so that the high frequency circuits are shielded from one another.

With this configuration, each of the plurality of high frequency circuits is shielded by the earth pattern and the metal film, while the high frequency circuits mounted on the upper portion printed board and the high frequency circuits mounted on the lower portion printed board are adjacent to each other alternately above and below.

Further, the high frequency multilayer printed circuit board may be characterized in that at least one portion of the metal film of the side surface of each of the holes of the intermediate portion printed board, the earth pattern of the lower pattern printed board, and the earth pattern of the upper portion printed board is electrically separated, and an input/output pattern of a high frequency circuit mounted on the lower portion printed board or a high frequency circuit mounted on the upper portion printed board is formed in the separated portion.

Further, the high frequency multilayer printed circuit board may be characterized in that at least one of the intermediate portion printed board, the lower pattern printed board and the upper portion printed board has a multilayer structure with an internal layer.

Further, the high frequency multilayer printed circuit board may be characterized in that the earth pattern of the upper portion printed board or the lower portion printed board in a surface opposite to the high frequency circuits mounted thereon is provided in an internal layer of the upper portion printed board or the lower portion printed board.

Further, the high frequency multilayer printed circuit board may be characterized in that a vent hole is provided in at least one of a shielded space formed by the lower portion printed board and the intermediate portion printed board and a shielded space formed by the upper portion printed board and the intermediate portion printed board.

Further, the high frequency multilayer printed circuit board may be characterized in that at least one of the intermediate portion printed board, the upper pattern printed board and the lower portion printed board is produced separately, and these boards are formed as a multilayer structure by means of brazing, screwing, bonding, or the like.

### Brief Description of the Drawings

Fig. 1 is a longitudinal sectional view showing a high frequency multilayer printed circuit board according to a first embodiment of the present invention.
Fig. 2 is an exploded perspective view showing the high frequency multilayer printed circuit board shown in Fig. 1.
Fig. 3 is a longitudinal sectional view showing a high frequency multilayer printed circuit board according to a second embodiment of the present invention.
Fig. 4 is a longitudinal sectional view showing a high frequency multilayer printed circuit board according to a third embodiment of the present invention.
Fig. 5 is a longitudinal sectional view showing a high frequency multilayer printed circuit board according to a fourth embodiment of the present invention.
Fig. 6(a) is a partially sectional view showing an example of a background-art shield structure.
Fig. 6(b) is a top view showing the example of the background-art shield structure.

### Best Mode for Carrying Out the Invention

Embodiments of the present invention will be described below with reference to the drawings.

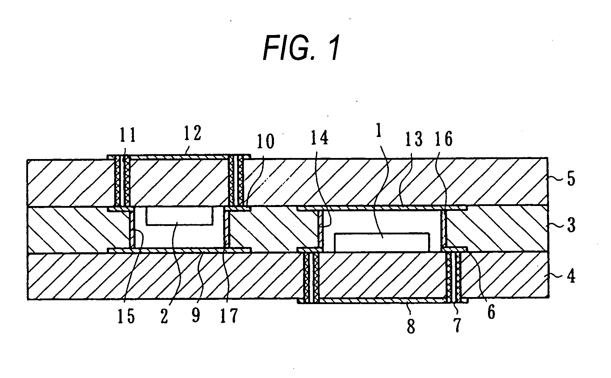

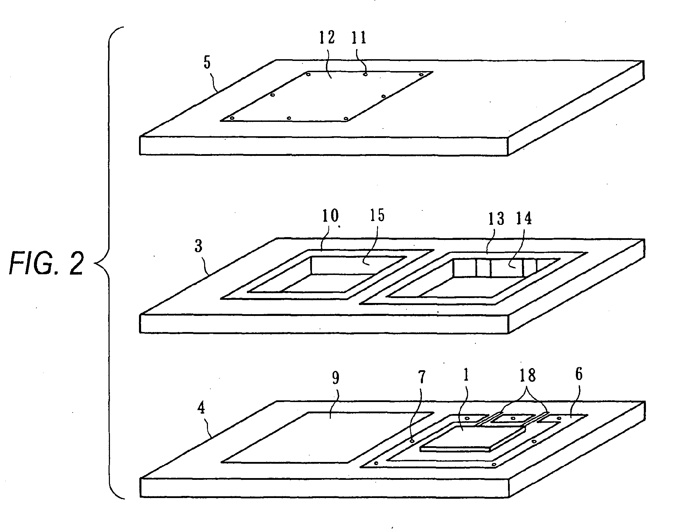

A high frequency multilayer printed circuit board according to a first embodiment of the present invention is chiefly constituted by an upper portion printed board 5, a lower portion printed board 4 and an intermediate portion printed board 3 as shown in Figs. 1 and 2. High frequency circuits 1 needing to be shielded from one another are mounted on the lower portion printed board 4 so that each high frequency circuit 1 is surrounded by an earth pattern 6. An earth pattern 8 electrically connected to the earth pattern 6 through through holes 7 is formed on the other surface of the lower portion printed board 4.

On the other hand, high frequency circuits 2 needing to be shielded from one another are mounted on the upper portion printed board 5 so that each high frequency circuit 2 is surrounded by an earth pattern 10. An earth pattern 12 electrically connected to the earth pattern 10 through through-holes 11 is formed on the other surface of the upper portion printed board 5 in the same manner as in the lower portion printed board 4.

The intermediate portion printed board 3 is put between the upper portion printed board 5 and the lower portion printed board 4 on the upper and lower surfaces thereof so as to constitute a part of the high frequency multilayer printed circuit board. Holes 14 and 15 are provided in the positions where the high frequency circuits 1 and the high frequency circuits 2 will be mounted, respectively. That is, when the upper portion printed board 5, the intermediate portion printed board 3 and the lower portion printed board 4 are put on top of one another, each high frequency circuit 1 and each high frequency circuit 2 mounted thereon are designed to be adjacent to each other through the intermediate portion printed board 3.

Further, a metal film 16 is formed in the side surface (wall surface) of each hole 14 by plating or the like, while an earth pattern 13 is formed in a portion located above each high frequency circuit 1 in the upper portion printed board 5. The earth pattern 13, the metal film 16 and the earth pattern 6 are designed to be electrically connected in the state where the three printed boards are laminated to one another.

In the same manner, a metal film 17 is formed in the side surface (wall surface) of each hole 15 by plating or the like, while an earth pattern 9 is formed in a portion located under each high frequency circuit 2 in the lower portion printed board 4. The earth pattern 9, the metal film 17 and the earth pattern 10 are designed to be electrically connected in the state where the three printed boards are laminated to one another.

Due to such a configuration of the printed circuit board, each high frequency circuit 1 is shielded by the earth pattern 13, the metal film 16, the earth pattern 6, the through holes 7 and the earth pattern 8, while each high frequency circuit 2 is shielded by the earth pattern 9, the metal film 17, the earth pattern 10, the through holes 11 and the earth pattern 12.

Signals leaking from the high frequency circuits 1 pass the clearance of the through holes 7, pass the lower portion printed board 4, the intermediate portion printed board 3 and the upper portion printed board 5, pass the clearance of the through holes 11, and propagate to the high frequency circuits 2. On the other hand, signals leaking from the high frequency circuits 2 propagate to the high frequency circuits 1 through a path opposite to the above-mentioned path. Accordingly, as shown in this embodiment, the high frequency circuits 2 mounted on the upper portion printed board 5 and the high frequency circuits 1 mounted on the lower portion printed board 4 are adjacent to each other alternately above and below. Thus, intensive shielding effect can be expected as compared with the case where the high frequency circuits 1 and the high frequency circuits 2 are mounted on one and the same board. In addition, influence when the alignment intervals of the through holes 7 or the through holes 11 are widened is also lower than that in the case where the high frequency circuits 1 and the high frequency circuits 2 are mounted on one and the same board.

Further, in this embodiment, an input/output pattern 18 of each high frequency circuit 1 is formed on the surface of the lower portion printed board 4 as shown in Fig. 2. Then, a slit for avoiding short-circuit between the input/output pattern 18 and the earth is provided in the earth pattern 6 surrounding the high frequency circuit 1 and the metal film 16 shielding the hole 14. With such a configuration, the slit provided in the earth pattern 6 and the metal film 16 can be formed to be extremely narrow in width. Thus, input/output signals can be exchanged with little influence on the shielding effect on the high frequency circuit 1.

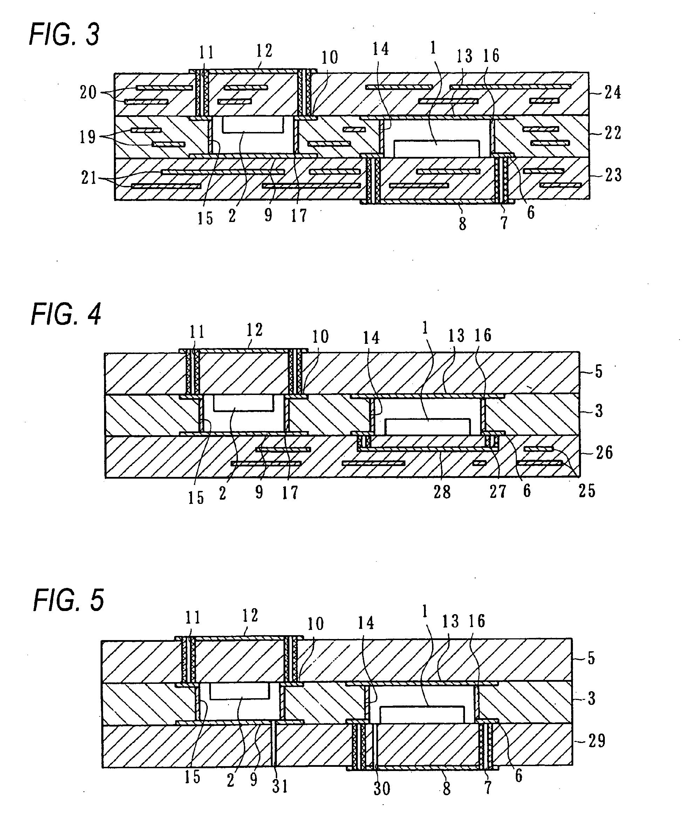

Next, description will be made about a second embodiment of the present invention. Incidentally, constituent parts similar to those in the aforementioned embodiment are denoted by the same reference numerals correspondingly, and detailed description thereof will be omitted. In a high frequency multilayer printed circuit board according to this embodiment, the intermediate portion printed board 3, the upper portion printed board 5 and the lower portion printed board 4 in the aforementioned first embodiment are replaced by an intermediate portion multilayer printed board 22 having internal layer patterns 19, an upper portion multilayer printed board 24 having internal layer patterns 20, and a lower portion multilayer printed board 23 having internal layer patterns 21, respectively, as shown in Fig. 3. With such a configuration, an intensive shielding effect can be expected between each high frequency circuit 1 and each high frequency circuit 2 in the same manner as in the first embodiment, while miniaturization can be also expected by making each printed board multilayer.

Incidentally, although the case where each printed board is made multilayer has been described in this embodiment, the aforementioned effect of minaturization can be expected if at least one of the aforementioned printed boards is made multilayer.

Next, description will be made about a third embodiment of the present invention. Incidentally, constituent parts similar to those in the aforementioned embodiments are denoted by the same reference numerals correspondingly, and detailed description thereof will be omitted. A high frequency multilayer printed circuit board according to this embodiment is constituted by an intermediate portion printed board 3 and an upper portion printed board 5 similar to those in the aforementioned first embodiment, and a lower portion multilayer printed board 26 having internal layer patterns 25 as shown in Fig. 4.

An internal layer earth pattern 28 is formed as a part of the internal layer patterns 25 of the lower portion multilayer printed board 26 configured thus. Through holes 27 are provided to extend from the earth pattern 6 to the internal layer earth pattern 28, while the internal layer earth pattern 28, the through holes 27, the earth pattern 6, the metal film 16 and the earth pattern 13 are designed to be electrically connected.

Consequently, each high frequency circuit 1 in this embodiment is shielded by the internal layer earth pattern 28, the through holes 27, the earth pattern 6, the metal film 16 and the earth pattern 13. Accordingly, the internal layer earth pattern 28 is made good use of so that the length of the through holes 27 to be linked therewith can be shortened. In addition, the distance between the through holes 27 is narrowed so that an intensive shielding effect can be expected between each high frequency circuit 1 and each high frequency circuit 2 as compared with that according to the first embodiment.

Although the through holes 27 are formed only between the earth pattern 6 and the internal layer earth pattern 28 in this embodiment, no problem will occur if the through holes 27 are formed to penetrate the lower portion multilayer printed board 26. In addition, although Fig. 4 shows the high frequency multilayer printed circuit board in which the lower portion printed board has a multilayer structure while the upper portion printed board has no internal layer pattern, a more intensive shielding effect can be expected if the upper portion printed board 5 is also made to have a structure similar to that of the lower portion multilayer printed board 26.

Next, description will be made about a fourth embodiment of the present invention. Incidentally, constituent parts similar to those in the aforementioned embodiments are denoted by the same reference numerals correspondingly, and detailed description thereof will be omitted. In a high frequency multilayer printed circuit board according to this embodiment, vent holes 30 and 31 are formed to penetrate a lower portion printed board 29, as shown in Fig. 5. These vent holes 30 and 31 are holes for connecting holes 14 and 15 (that is, shielded spaces receiving high frequency circuits) with the outside air. The vent holes 30 and 31 may be through holes or non-through holes.

According to this embodiment, the air expanded inside the holes 14 and 15 due to temperature rise or the like are discharged to the outside air through the vent holes 30 and 31. It is therefore possible to avoid problems caused by the expansion of the air, such as peeling or damage of the multilayer board. Thus, the reliability against these problems can be enhanced.

The embodiments of the present invention have been described above. However, the present invention is not limited to these embodiments. For example, a multilayer structure may be formed as follows. That is, a lower portion printed board, an intermediate portion printed board and an upper portion printed board are produced individually in advance. These boards are laminated to one another by brazing using means such as solder or the like, screwing, or means using a bonding agent or the like. It is desired that the bonding agent used at this time is conductive to secure electric connection among earth patterns of the respective boards. When the respective boards are produced individually, it is easy to combine printed board materials different in quality in accordance with application, or to form shield spaces having complicated shapes.

### Industrial Applicability

As has been described above, according to the present, invention, high frequency circuits needing to be shielded from one another and to be disposed in adjacent positions are mounted on different board surfaces, so that high frequency circuits mounted on an upper portion printed board and high frequency circuits mounted on a lower portion printed board are adjacent to each other alternately above and below. Thus, a high frequency multilayer printed circuit board having an effect that a more intensive shielding effect can be expected can be provided for equipment having a plurality of high frequency circuits needing to have a shielding effect from one another.

## Claims

1. A high frequency multilayer printed circuit board mounted with a plurality of high frequency circuits needing to be shielded, comprising:
an intermediate portion printed board in which holes are made in positions where high frequency circuits will be disposed respectively, and a metal film is formed in a side surface of each of said holes;
a lower portion printed board in which high frequency circuits each surrounded by an earth pattern are mounted on one surface, while the other surface is formed as an earth pattern; and
an upper portion printed board in which other high frequency circuits needing to be shielded from said high frequency circuits are mounted on one surface, and an earth pattern is formed around each of said other high frequency circuits, while the other surface is formed as an earth pattern;
wherein said high frequency circuits mounted on said lower portion printed board are made adjacent to said high frequency circuits mounted on said upper portion printed board, while these lower portion printed board and upper portion printed board are put on each other through said intermediate portion printed board;
a surface of said upper printed board facing said high frequency circuits mounted on said lower portion printed board serves as an earth pattern of said upper printed board;
a surface of said lower printed board facing said high frequency circuits mounted on said upper portion printed board serves as an earth pattern of said lower printed board; and
said earth pattern of said lower pattern printed board, said metal film of said side surface of each of said holes of said intermediate portion printed board, and said earth pattern of said upper portion printed board are connected electrically so that said high frequency circuits are shielded from one another.

2. A high frequency multilayer printed circuit according to Claim 1, wherein at least one portion of said metal film of said side surface of each of said holes of said intermediate portion printed board, said earth pattern of said lower pattern printed board, and said earth pattern of said upper portion printed board is electrically separated, and an input/output pattern of a high frequency circuit mounted on said lower portion printed board or a high frequency circuit mounted on said upper portion printed board is formed in said separated portion.

3. A high frequency multilayer printed circuit according to Claim 1, wherein at least one of said intermediate portion printed board, said lower pattern printed board and said upper portion printed board has a multilayer structure with an internal layer pattern.

4. A high frequency multilayer printed circuit according to Claim 3, wherein said earth pattern of said upper portion printed board or said lower portion printed board in a surface opposite to said high frequency circuits mounted thereon is provided in an internal layer of said upper portion printed board or said lower portion printed board.

5. A high frequency multilayer printed circuit according to any one of Claims 1 to 4, wherein a vent hole is provided in at least one of a shielded space formed by said lower portion printed board and said intermediate portion printed board and a shielded space formed by said upper portion printed board and said intermediate portion printed board.

6. A high frequency multilayer printed circuit according to any one of Claims 1 to 4, wherein at least one of said intermediate portion printed board, said upper pattern printed board and said lower portion printed board is produced separately, and these boards are formed as a multilayer structure by means of brazing, screwing, bonding, or the like.
